# EUROPEAN PATENT APPLICATION

(11) **EP 1 093 165 A1**
(43) Date of publication of application: **18.04.2001**
(21) Application number: 00308292.2
(22) Date of filing: 22.09.2000
(51) Int. Cl.: H01L 25/18

(54) **Integrated circuit assembly**

(30) Priority: 12.10.1999 US 416617
(71) Applicant: Agilent Technologies Inc., Santa Clara, California 95052-8043 (US)
(72) Inventor: Bledsoe, James Daren, Albany, OR 97321 (US); Kelly, Michael G., Corvallis, Oregon 97330 (US); Croft, Daniel I., Monmouth, OR 97361 (US)
(74) Representative: Jehan, Robert

(57) **Abstract**

An integrated circuit assembly (10) includes a daughter die (22) stacked on top of a mother die (14). The upper surface of the mother die includes a number of conductive contact pads (26, 64), and the lower surface of the daughter die has a number of corresponding conductive contact pads (52, 64) registered with and each electrically connected to a respective one of the contact pads of the mother die. The pads may be distributed to arbitrary locations, including away from the daughter die periphery. The circuit layers (32, 52) of the dies may face each other, and the dies may be connected by a conductive layer (56) or solder bumps (60).

## Description

This invention relates to an integrated circuit assembly, for example a multi-chip integrated circuit assembly.

Electronic devices use integrated circuit chips for controlling complex operations in a miniature package. Application specific integrated circuit (ASIC) devices are custom designed to provide a particular function. As manufacturing processes are developed that allow smaller geometries with narrower traces and spacings of the circuit pattern, the size of ASIC chips may be reduced, reducing part size and cost, or increasing functional capability for a given chip size. However, smaller geometries below a certain threshold are not suitable for the moderate input and output (I/O) voltages that are needed by other electronic components with which the ASIC chip interfaces.

In addition, a chip produced by a selected integrated circuit manufacturing process may lack certain desired functionality. For instance, a chip produced to optimise miniaturisation for digital data processing functions (e.g. CMOS) may be unsuitable for analogue signal processing, DRAM, FeRAM, or FLASH functions that might ideally be desired in a single circuit. Even where it is possible to combine normally incompatible functions on a chip, the result is compromised for one or more of the functions.

Currently, to provide for two or more incompatible IC processes, multiple chips are needed. With normal spatial separation between components, the extended connections limit the speed of operation are susceptible to inductance and EMI, suffer increased manufacturing and component costs, and undesirably increased size. To provide a compact size, multiple chips have been included in a single package. For instance, US Patent No. 5,777,345 discloses a multi-chip integrated circuit package in which a die is mounted to the upper surface of a larger die. The peripheral bond pads of the upper die are connected by wire bonds to peripheral pads of the supporting die, which is bonded to surrounding pads of a lead frame. However, this approach has limited flexibility in the placement of pads, as well as the size, number and position of the upper die relative to the supporting die in order to maintain bond lengths within normal ranges. Further, the long wire bonds and constrained pad locations forces longer traces and loop wires, leading to increased inductance effects. The height of the bond wire loops must also be accommodated in a protective package, with a taller profile than would otherwise be required. Also, the gap between the circuitry on the upper portions of each stacked die limits EMI benefits, and the upper surface of the upper die is unshielded.

The present invention seeks to provide an improved integrated circuit assembly.

According to an aspect of the present invention, there is provided an integrated circuit assembly as specified in claim 1.

The preferred embodiments can overcome the limitations of the prior art by providing an integrated circuit assembly with daughter die stacked on top of a mother die, the upper surface of the mother die including a number of conductive contact pads, and the lower surface of the daughter die having a number of corresponding conductive contact pads registered with and each electrically connected to a respective one of the contact pads of the mother die. The pads may be distributed to arbitrary locations, including away from the daughter die periphery. The circuit layers of the dies may face each other, and the dies may be connected by a conductive layer or solder bumps.

Embodiments of the present invention are described below, by way of example only, with reference to the accompanying drawings, in which:
Fig. 1 is a sectional side view of a preferred embodiment of circuit assembly taken along line 1-1 of Figure 2;
Fig. 2 is a plan view of the circuit assembly of Figure 1;
Fig. 3 is a plan view of another embodiment of circuit assembly;
Figs. 4, 5 and 6 are exploded sectional side views of alternative embodiments of assembly.

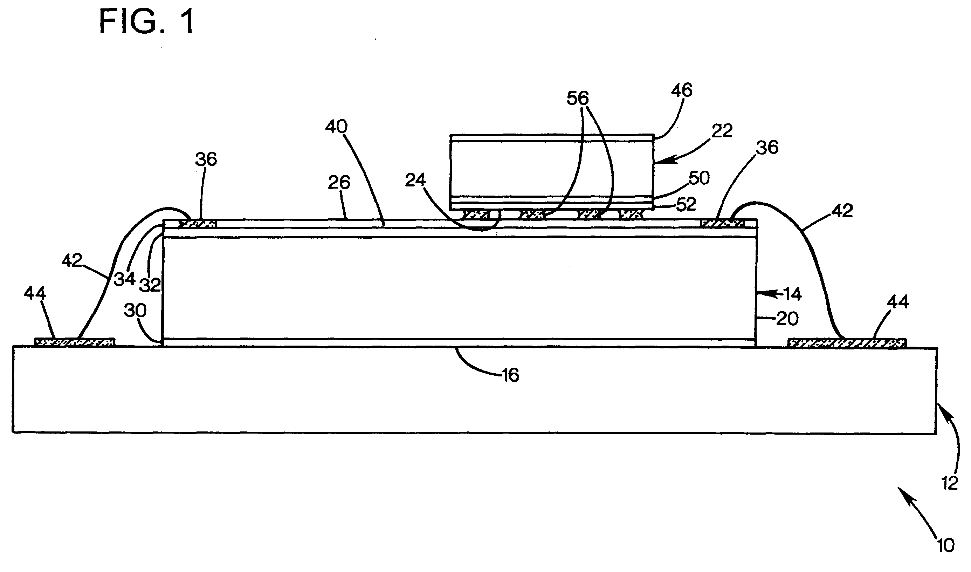

Figure 1 shows a circuit assembly 10 including a printed circuit substrate 12, a first integrated circuit chip or mother die 14 having a lower surface 16 connected to an upper surface 20 of the substrate. A second integrated circuit chip or daughter die 22 has a lower surface 24 electrically and mechanically connected to an upper surface 26 of the mother die.

The mother die has a metal ground plane 30 at its lower surface, and has an upper circuitry portion 32 near the upper surface 26 that contains multiple layers with the functional circuitry of the chip. An upper layer 34 includes metal bond pads 36 at the periphery of the upper surface, and a redistribution layer material 40 that includes electrical connections between mother die circuitry and the bond pads and other selected locations of the upper surface. Bond wires 42 connect each bond pad 36 to a respective bond pad 44 on the substrate.

The daughter die 22 is upside down relative to the mother die, with a ground plane 46 facing upwardly away from the mother die, and a circuitry portion 50 facing downwardly towards the mother die. A redistribution layer 52 covers the circuit portion and provides selected electrical connections between selected regions of the daughter die's lower surface and circuit elements in the circuitry portion 50.

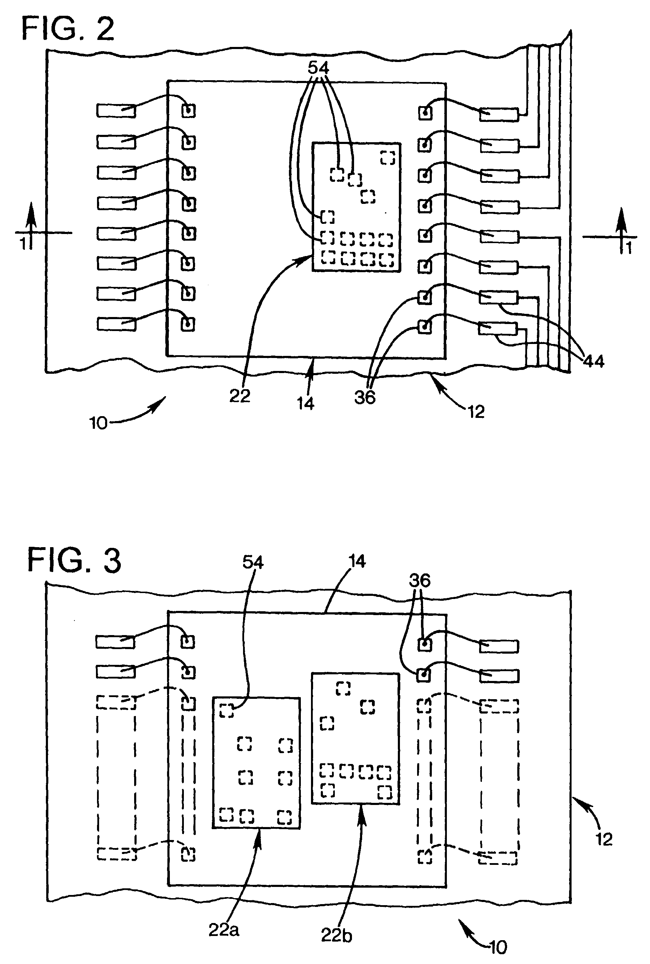

As shown in Figure 2, a number of contact locations 54 are distributed about the area of the daughter die. At each of these locations, an electrical connection is made between the dies. In the illustrated embodiment, the connection is made by a solder joint 56 formed of solder bumps pre-printed to the surface to at least one of the dies. The contact location may be arranged without constraint, for an essentially arbitrary arrangement of connection locations over the daughter die surface, including peripheral locations as well as central and intermediate locations. Except for a minimum spacing between locations to avoid shorting, any location is acceptable. This allows the entire surface to be filled with a multitude of connections, if needed, and allows connections to be made at the location where the circuitry on the daughter (or mother) die would be optimally located.

By avoiding excessive use of routing traces to the locations, die area may be reduced, and EMI concerns are also reduced.

In a preferred embodiment, the mother die and daughter die are produced from different semiconductor chip production process standards, with each standard selected to optimise performance, costs, and other priorities for each chip. In one example, the mother die is a high speed CMOS chip with minimum size pattern geometries for use with low voltage signals. The daughter die is produced to a larger geometry process standard and contains driver circuitry for converting low voltage signals to higher line voltages required by other circuitry located elsewhere on the substrate or external to the substrate. Thus, an output signal generated on the mother die using its high speed capability is transmitted up to the daughter die via one connection 56, where the daughter's circuitry steps the signal up to a higher voltage. The higher voltage signal is transmitted down to the mother die via a different connection. From there, a wider-than-minimum-standard trace with appropriate "keep out" spacing on the mother die carries the higher voltage signal to a bond pad 36. Other circuitry on the mother die may be spaced appropriately away from the high voltage trace to avoid EMI effects. While the mother die may be capable of carrying a simple higher voltage signal, it is incapable of processing signals at such a voltage.

In the preferred embodiment, the dies are oriented face-to-face with substantially no spacing other than the minimum thickness of the solder joints. This abutting of the surfaces serves to minimise the conductive path length, thus reducing inductance and EMI effects. In addition, having the ground planes 30, 46 at the outermost surfaces of the sandwich creates a "Faraday cage" that further reduces EMI concerns. substantially all the daughter die circuitry and a portion of the mother die circuitry are contained between the ground planes of the cage. Also, the highest surface of the package, the daughter die's ground plane, is particularly robust, as it contains no delicate circuitry or connections. Even without a cover or encapsulant, a robust assembly is provided.

Moreover, the lack of protruding bonds reduces the necessary package height, which can be an important factor for compact electronic devices in which the assembly is to be used. As the mother and daughter dies are preferably based on the same silicon substrate material, they share a coefficient of thermal expansion, and withstand a wide range of temperatures without significant stresses at the connections.

As shown in Figure 3, multiple daughter dies 22a, 22b may be installed on a single mother die. These daughter dies may be of different sizes, different functional capabilities, and produced from different processes. The daughter dies may be positioned adjacent each other where dimensional tolerances are precise or with minimal spacing as shown to allow registration to connection locations 54 in spite of any variations in edge dimensions of the daughter dies relative to the daughter pattern. As in the preferred embodiment, daughter dies may be located at any position other than the region of the bond pads and required clearance for bonding. Where the mother die is connected by means not requiring significant height or clearance, daughter dies may be connected at any location.

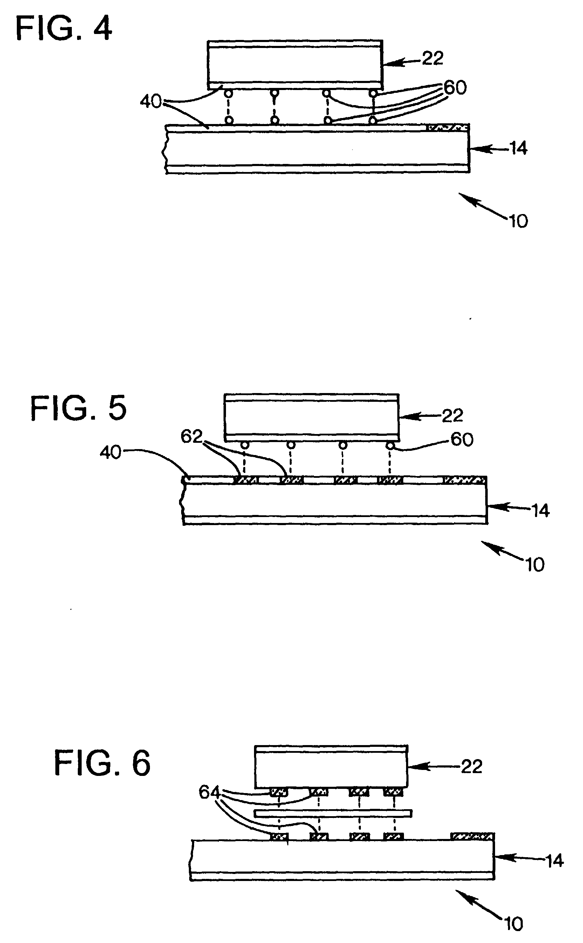

The daughter die may be attached to the mother die by any suitable means of making connection between the front surfaces of two semiconductor chips. Figure 4 shows the preferred embodiment, in which each of the mother and daughter has a solder bump 60 for each connection. The solder bumps are connected to a redistribution layer 40 on each die, which provides electrical connection to desired circuitry. Figure 5 shows a variation in which the daughter die has solder bumps 60, and the mother die has locating metal contacts 62 in corresponding locations. The surface tension effects of melted solder cause the daughter to be self-aligning during the soldering process.

Figure 6 shows another alternative in which metal or redistribution layer contact pads 64 are provided at each connection location on both the daughter and mother. In a solder-free process, a conductive adhesive having anisotropic properties that allows only vertical conduction, preventing shorts between adjacent connections. Such adhesives are also known as "Z-axis" adhesives. The adhesive may be a liquid or paste that is distributed across the entire surface, or may be selectively applied to individual pads, in which case it may be isotropic. Alternatively, a sheet or coupon of solid conductive adhesive may be positioned between the mother and daughter contacts for Z-axis conduction, with the adhesive activated and cured by a thermal process.

While the above is discussed in terms of preferred and alternative embodiments, the invention is not intended to be so limited.

It is to be understood that the individual features of the different embodiments described herein may be used in all of the implementations of the present invention.

The disclosures in United States patent application no. 09/416,617, from which this application claims priority, and in the abstract accompanying this application are incorporated herein.

## Claims

1. An integrated circuit assembly comprising:
a mother die (14) including an upper surface (26) with a plurality of conductive contact pads (40, 62);
a daughter die (22) connected to the upper surface of the mother die; the daughter die including a lower surface with a plurality of conductive contact pads (52) registered with and each electrically connected to a respective one of the contact pads of the mother die.

2. An assembly according to claim 1, wherein the upper surface of the mother die includes a plurality of circuit layers (32), and the lower surface of the daughter die includes a plurality of circuit layers (50), the circuit layers of the dies being arranged in face-to-face manner.

3. An assembly according to claim 1 or 2, including a conductive layer (56) between the dies.

4. An assembly according to any preceding claim, wherein at least some of the contact pads include solder bumps (60).

5. An assembly according to any preceding claim, wherein the daughter die includes a peripheral edge, at least some of the contact pads (54) being spaced from the edge by different amounts.

6. An assembly according to any preceding claim, wherein the mother die (14) is produced to a different process standard than is the daughter die.

7. An assembly according to any preceding claim, wherein the mother die (14) has a smaller minimum trace width than the daughter die.

8. An assembly according to any preceding claim, wherein the daughter die (22) has a higher voltage capability than the mother die.

9. An assembly according to any preceding claim, wherein the mother die has at least a higher voltage capable trace connecting one of the contact pads to an external contact pad (40) spaced from the daughter die.

10. An assembly according to any preceding claim, including a second daughter die (22b) connected to the upper surface of the mother die.
